Europäisches Patentamt

European Patent Office

Office européen des brevets

(11) Numéro de publication: **0 192 500**
**A1**

## DEMANDE DE BREVET EUROPEEN

(21) Numéro de dépôt: 86400058.3

(22) Date de dépôt: 13.01.86

(51) Int. Cl.⁴: **G 01 R 19/25**

(30) Priorité: 22.01.85 FR 8500851

(43) Date de publication de la demande:
27.08.86 Bulletin 86/35

(84) Etats contractants désignés:
CH DE GB IT LI

(71) Demandeur: **ITT COMPOSANTS ET INSTRUMENTS**
**157, rue des Blains**
**F-92220 Bagneux(FR)**

(72) Inventeur: **Lher, Pierre**
**2, rue François Vernex**
**F-74000 Meythet(FR)**

(72) Inventeur: **Oses, Pascal**
**55, chemin des Fins**
**F-74000 Annecy(FR)**

(74) Mandataire: **Pothet, Jean et al,**
**c/o ITT Data Systems France S.A. Tour Maine**
**Montparnasse 33, avenue du Maine**
**F-75755 Paris Cédex 15(FR)**

(54) Multimètre numérique à convertisseur double-rampe.

(57) Multimètre numérique à convertisseur à double-rampe comprenant des calibres d'entrée, des commutateurs d'entrée (S1 à S11), un convertisseur analogique-numérique et un afficheur, le convertisseur analogique-numérique comprenant un étage d'entrée (AE), un étage intégrateur (AI) et un comparateur (CP) ainsi que des commutateurs (S22 à S28) permettant de connecter à l'entrée du convertisseur soit une masse pour la phase d'auto-zéro, soit la tension d'entrée à convertir, soit une tension de référence, la phase d'auto-zéro consistant à établir une boucle maintenant la sortie du comparateur à un niveau quasi-nul et à mémoriser dans un condensateur de compensation, le niveau de tension alors présent à l'entrée de l'intégrateur.

Ce multimètre comprend encore une source de tension de compensation ajustable (GC-RC) arrangée de manière à être connectée à l'entrée du convertisseur analogique-numérique, à la place de la masse, pendant la phase d'auto-zéro, afin que la tension de compensation ainsi apportée soit mémorisée dans le condensateur de compensation (CC), le signe et l'amplitude de cette tension de compensation étant tels que sa présence ultérieure dans le cycle de fonctionnement du convertisseur se traduise par une réduction d'erreurs systématiques affectant la mesure.

Fig. 1

Croydon Printing Company Ltd.

La présente invention concerne les multimètres numériques à convertisseur à double-rampe et a plus particulièrement pour objet des dispositions visant à une compensation de certaines erreurs systématiques dans de tels appareils.

Les multimètres numériques sont des appareils de mesure de grandeurs électriques (tensions, courants, résistance, etc.) à plusieurs échelles (0,2, 2, 20, 200 V, par exemple), fournissant un affichage numérique de la valeur mesurée. Ils comportent donc essentiellement :

- des calibres d'entrée (résistances d'un diviseur de tension, résistances série pour mesure de courant, etc.),
- des commutateurs d'entrée mettant en service les calibres appropriés,
- un convertisseur analogique-numérique,
- un afficheur.

Il existe sur le marché des convertisseurs analogiques-numériques à double-rampe appropriés à cet usage (voir en particulier l'ouvrage "Hot ideas in CMOS" de la Société INTERSIL, Edition 1984, pages 4-98 à 4-103), comprenant un étage d'entrée, un étage intégrateur et un comparateur, ainsi que des commutateurs. Un condensateur de compensation ("auto zero") est également prévu. Le fonctionnement du convertisseur comprend trois phases accomplies cycliquement, dont la première est une phase d'auto-zéro dans laquelle l'entrée de l'étage d'entrée est mise à la masse par un commutateur, tandis qu'un autre commutateur reboucle la sortie du comparateur sur l'entrée de l'intégrateur. Le condensateur de compensation se charge à la tension d'équilibre acquise par le système dans ces conditions (tension d'erreur). Ensuite, pendant un intervalle de temps défini, l'étage d'entrée reçoit le signal à évaluer et un condensateur d'intégration acquiert une charge proportionnelle à l'amplitude de ce signal. Enfin, une tension de référence est fournie à l'étage d'entrée, de signe opposé à celui du signal à évaluer, et le condensateur d'intégration se décharge sous courant constant. La durée de cette dernière opération est représentative de l'amplitude du signal à évaluer. Elle est mesurée en comptant les périodes d'une onde à fréquence élevée très stable.

Durant ces deux dernières opérations, le condensateur de compensation se trouve inclus dans le circuit d'entrée de l'étage intégrateur et il maintient sur l'entrée la tension d'erreur qu'il a précédemment reçue, corrigeant ainsi les écarts et dérives préjudiciables à la précision de la mesure.

De tels appareils souffrent toutefois d'autres causes d'erreurs systématiques, notamment dans le cas où l'on considère une réalisation dans laquelle non seulement le convertisseur analogique-numérique, mais aussi la plupart des circuits d'entrée sont inclus dans un même circuit intégré, notamment de type CMOS.

En effet, les commutateurs de type CMOS possèdent des courants de fuite, ainsi qu'il est exposé dans l'ouvrage "Analog Device Databook" Vol. 1, 1984, pages 20-49 et 20-50, qui résultent de déséquilibres de courants, ce qui signifie que le sens et l'amplitude du courant de fuite de chaque commutateur dépendent des conditions de fabrication. Les circuits d'entrée dans le circuit intégré, avec les circuits de protection associés aux plates-formes ("pads") de la puce de silicium, ont des caractéristiques semblables et causent eux aussi des courants de fuite.

De tels courant sont faibles, généralement de l'ordre de quelques picoampères et on essaie habituellement de les réduire à une valeur telle qu'ils ne soient pas gênants. Toutefois, cela implique des efforts coûteux dans la production des circuits intégrés, pour un résultat imparfait, tendant à devenir insuffisant, étant donné les besoins de précision des appareils de mesure modernes.

Pour ne pas perturber la source de la grandeur à mesurer (tension en particulier), il est souhaitable que l'impédance d'entrée de l'appareil ait une valeur élevée. Une résistance de forte valeur est ainsi connectée dans le circuit d'entrée de l'appareil. Dans le premier document cité, il est ainsi fait mention d'une résistance de 100 k$\Omega$ . Mais on s'oriente vers des valeurs bien supérieures, 10 M$\Omega$ par exemple. Or, le courant de fuite venant d'un circuit intégré incluant, par exemple, cinq commutateurs et une plate-forme en relation avec l'entrée de signal à mesurer, peut atteindre 10 pA. La tension qui en résulte, aux bornes de la résistance d'entrée est de 100$\mu$V. Elle se manifeste donc par une erreur atteignant déjà un point d'échelle pour un appareil mesurant 200mV sur 2000 points ou 400mV sur 4000 points et atteignant 10 points d'échelle pour un appareil mesurant 200mV sur 20 000 points.

L'invention a donc pour objet principal des dispositions permettant de réduire considérablement une telle erreur systématique et toute autre erreur de même nature.

Cela est obtenu par le fait que l'on prévoit une source de tension de compensation ajustable arrangée de manière à être connectée à l'entrée du convertisseur analogique-numérique pendant la phase d'auto-zéro, afin que la tension de compensation ainsi apportée soit mémorisée en même temps que la tension d'erreur par le condensateur de compensation. Le signe et l'amplitude de cette tension de compensation seront tels que sa présence ultérieure dans le cycle de fonctionnement du convertisseur se traduise par une réduction d'erreurs systématiques affectant la mesure.

Avantageusement, on réalisera la source de tension de compensation sous la forme d'un générateur de courant de compensation inclus dans un même circuit intégré que la plupart des autres circuits actifs de l'appareil, associé à une résistance disposée à l'extérieur de ce circuit intégré, dont la valeur pourra être choisie pour améliorer la réduction des erreurs.

De plus, on pourra réaliser ce générateur de courant sous la forme d'un circuit analogue dans son principe et sa constitution physique à l'ensemble des circuits qui sont cause de l'erreur à compenser. On peut ainsi obtenir une adéquation permanente, y compris en température, entre l'erreur et sa correction.

Du fait que toutes les mesures ne souffrent pas de l'erreur considérée, l'invention prévoit en outre que la source de tension de compensation puisse être éliminée sur commande et remplacée par la masse. Cela sera avantageusement obtenu à l'aide d'un commutateur supplémentaire qui la court-circuitera.

Les différents objets et caractéristiques de l'invention seront maintenant détaillés dans la description qui va suivre, faite à titre d'exemple non limitatif, en se reportant aux figures annexées qui représentent :

- la figure 1, le schéma des étages d'entrée et du convertisseur d'un multimètre numérique incorporant les dispositions faisant l'objet de l'invention,

- la figure 2, le schéma théorique d'un commutateur analogique.

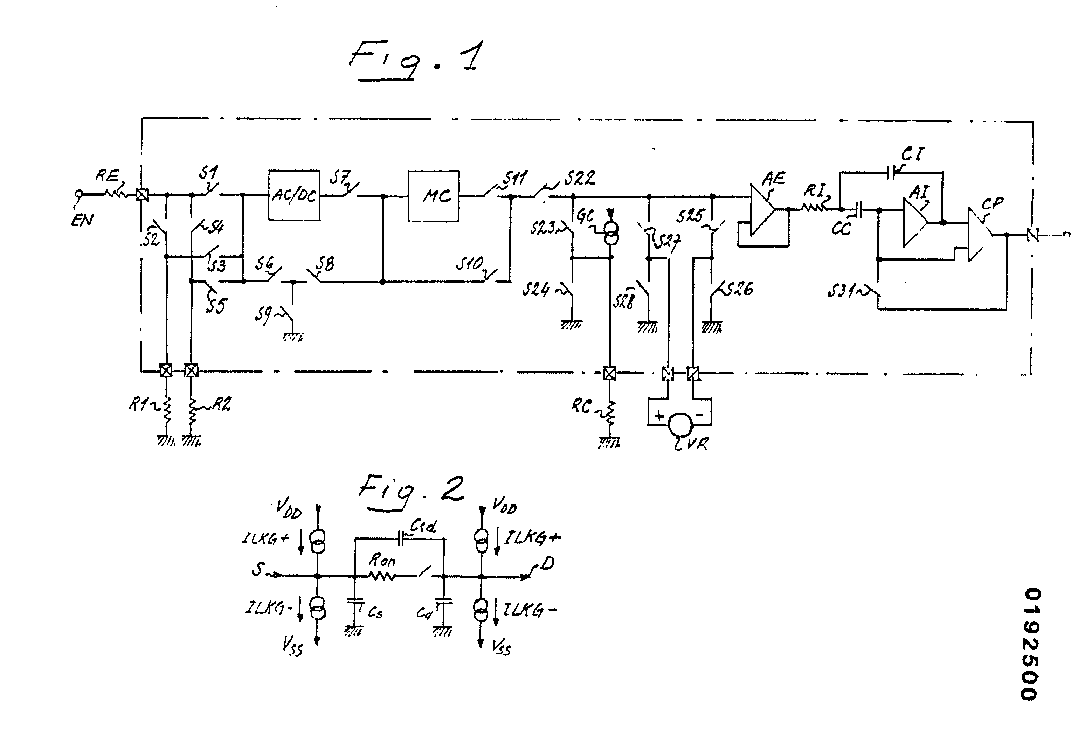

Le schéma de la figure 1 comprend une entrée EN, une résistance d'entrée RE, deux résistance potentiométriques R1 et R2, des commutateurs de calibres de tension S1 à S5, un convertisseur alternatif-continu AC/DC, des commutateurs de sélection S6 à S9, un circuit de mémoire de crête MC et ses commutateurs S10 et S11, un générateur de courant de compensation GC, une résistance de compensation RC et les commutateurs associés S23 et S24, un commutateur S22 pour l'introduction de la grandeur à évaluer, une source de tension de référence VR et ses quatre commutateurs S25 à S28, un amplificateur d'entrée AE, une résistance d'intégration RI, un amplificateur d'intégration AI, un condensateur d'intégration CI, un comparateur CP, un condensateur de compensation CC et, enfin, un commutateur d'auto-zéro S31.

Dans le cas d'une mesure de tension continue et si celle-ci est faible (calibre 200mV, par exemple), le commutateur S1 est fermé par une logique de commande non représentée et qui se trouve hors de l'objet de l'invention. Par suite, la tension d'entrée est transmise en totalité, par la résistance RE et le commutateur S1. Les commutateurs S6, S8 et S20 sont également fermés, de sorte que cette tension est disponible à l'entrée du commutateur S22.

Cette tension est évaluée par le convertisseur analogique-numérique à double-rampe dont le fonctionnement comprend trois phases répétées de façon cyclique.

Dans une première phase, dite d'auto-zéro, le commutateur S23 est fermé et apporte un potentiel fixe, que l'on supposera d'abord nul, à l'entrée du convertisseur. L'amplificateur AE, qui est un amplificateur différentiel dont l'entrée inverseuse est connectée à la sortie, présente à ce signal une forte impédance d'entrée et le répète sous basse impédance à sa sortie, entaché de sa propre erreur d'offset. Par ailleurs, la commutateur S31 est fermé et connecte la sortie du comparateur CP aux entrées inverseuses de l'amplificateur intégrateur AI et du comparateur CP. La sortie du comparateur CP vient à un potentiel correspondant à la tension d'erreur du système, que l'on mémorise et qui compensera dans les phases ultérieures de mesure les décalages de zéro des trois amplificateurs.

La mémorisation est assurée par le condensateur CC qui reçoit la tension d'erreur de l'amplificateur AE, d'une part, et la tension d'erreur des amplificateurs AI et CP, d'autre part, et qui se charge sous la somme de ces tensions. Cette phase dure, par exemple, 100ms.

Dans une seconde phase, servant à l'intégration de la tension d'entrée, le commutateur S22 seul est fermé. L'amplificateur AE reçoit et répète la tension d'entrée. La contre-réaction à travers le condensateur CI maintient à très peu près la tension entre la résistance RI et le condensateur CC à une valeur nulle. Le courant constant dans la résistance R1 est proportionnel à la tension d'entrée. Il charge le condensateur CI. Après une durée fixe, 100ms par exemple, le commutateur S22 s'ouvre et la tension aux bornes du condensateurs CI est proportionnelle à la tension d'entrée. Dès que le condensateur CI a commencé à se charger, le comparateur CP est venu à saturation, soit positivement, soit négativement, selon la polarité de la tension s'entrée.

Dans une troisième phase, où il est procédé à l'intégration d'une tension de référence, la tension VR est connectée à l'entrée de l'amplifica-

5

0192500

teur AE par deux des quatres commutateurs S25 à S28. Si l'on suppose que la tension d'entrée était positive, se sont les commutateurs S25 et S28 qui sont fermés pour que la tension appliquée soit -VR, par rapport à la masse. Les commutateurs S26 et S27 servent à fournir +VR à la suite d'une tension d'entrée négative. Cette tension VR fournit à l'intégrateur un courant fixe qui décharge le condensateur CI à une vitesse déterminée. La durée de cette opération jusqu'au retour à l'état initial dépendra donc de la tension d'entrée. Elle sera délimitée grâce au comparateur CP dont la sortie reviendra à zéro après que le condensateur CI ait été complètement déchargé. Le signal de sortie du comparateur sert ainsi, lorsqu'il est différent de zéro à commander le comptage des périodes d'une onde à fréquence élevée et stable qui permette l'obtention d'une valeur numérique représentant la valeur de la tension d'entrée. Lorsqu'il revient à zéro, il provoque l'ouverture des commutateurs et l'affichage du résultat du comptage. On notera que le condensateur CC a conservé durant ce temps la charge acquise pendant la phase d'auto-zéro de manière que la correction nécessaire soit toujours appliquée pour un retour au zéro dans les mêmes conditions que lors de la fixation initiale du zéro.

Si la tension d'entrée est plus élevée que dans le cas que l'on vient de décrire, les commutateurs S2 et S3 sont fermés au lieu du commutateur S1 et les résistances RE et R1 forment un diviseur de tension calibrant la tension fournie au convertisseur, par exemple, à un centième de la tension d'entrée. La résistance R2 et les commutateurs S4 et S5 permettent de même d'obtenir, par exemple, une réduction dans un autre rapport.

Si la tension d'entrée est alternative au lieu d'être continue, les commutateurs S6 et S8 sont ouverts (le commutateur S9 est fermé) et le commutateur S7 met en circuit le convertisseur AC/DC qui redresse la tension d'entrée.

Par un procédé analogue, grâce aux commutateurs S10 et S11, on peut faire apparaître la valeur maximale d'un signal d'entrée variable, par mémorisation dans le circuit MC de son amplitude de crête et fourniture de celle-ci au convertisseur à la place d'une valeur instantanée.

La présence des divers commutateurs dont on vient d'esquisser le rôle est cause d'une erreur systématique due à leur courant de fuite qui peut fausser les mesures nécessitant la plus grande sensibilité de l'appareil.

On se reportera à la figure 2 qui fournit le schéma théorique d'un commutateur CMOS tel que publié dans le second document cité. On voit que

l'entrée S est en quelque sorte connectée à deux générateurs de courant de fuite connectés entre le potentiel positif $V_{DD}$ et le potentiel négatif $V_{SS}$. Si les courants produits par ceux-ci, ILKG+ et ILKG- sont égaux, le courant de fuite résultant est nul, mais s'ils sont inégaux, il se produira un courant de fuite vers l'entrée S, soit dans un sens, soit dans l'autre. Il en va de même du côté de la sortie D, ce qui ajoutera un second courant de fuite du côté de l'entrée après la fermeture du commutateur, si le circuit côté sortie a comparativement une haute impédance, la résistance série Ron étant à ce point de vue négligeable.

La surface occupée par un tel commutateur dans le cas d'un circuit intégré est d'autant plus grande que la résistance série Ron doit être faible. Les capacités et courants de fuite sont en rapport avec la surface. Les valeurs propres des courants ILKG+ et ILKG- dépendent des conditions de fabrication. Elles ne sont pas totalement contrôlables. Toutefois, le fabricant peut respecter des valeurs maximales spécifiées.

En retournant à la figure 1, on peut juger que les courants de fuite des commutateurs S1, S2, S4 affectent l'entrée EN, auxquels s'ajoutent, lorsque le commutateur S1 est fermé, le courant de fuite des commutateurs S3, S5, S6, S8, S9, S10, S11, S22, etc.

Même si le courant de fuite d'un seul commutateur est de l'ordre du picoampère, l'ensemble peut atteindre la dizaine de picoampères. Or, comme exposé au début de ce texte, cela conduit à une différence de potentiel aux bornes de la résistance RE dont l'amplitude se traduit par une erreur sur la valeur affichée. Cette erreur est systématique. Les commutateurs, une fois fabriqués, ont un courant de fuite qui, s'il n'est contrôlable qu'à grands frais, est aisément déterminable. Il suffit d'introduire un niveau de tension nul et de le mesurer sur différents calibres. La mesure affichée, qui devrait être 00000, est alors celle de la tension aux bornes de la résistance RE. Cette erreur de mesure est presque constante. Elle est vite négligeable quand la grandeur à mesurer est d'une amplitude élevée, mais sa présence affecte significativement la mesure pour les grandeurs les plus faibles. Il importe donc de la réduire pour augmenter la précision de l'appareil aux limites de sa sensibilité.

Ce qui vient d'être exposé à propos des commutateurs peut être répété au sujet des plateformes ("pads", en anglais) correspondant aux connexions d'entrée-sortie d'un circuit intégré, représentées, sur la figure 1, par un carré contenant une croix en diagonales.

L'invention propose donc, pour pallier ces effets, d'incorporer dans l'appareil une source de tension de compensation ajustable arrangée de manière à être connectée à l'entrée du convertisseur analogique-numérique pendant la phase d'auto-zéro, afin que la tension de compensation ainsi apportée soit mémorisée dans le condensateur de compensation. Cette tension devra se soustraire à la tension d'entrée et en particulier à l'erreur que celle-ci contient, afin de réduire cette dernière.

Dans l'exemple de la figure 1, cette source prend la forme d'un générateur de courant GC alimentant une résistance de compensation RC et le commutateur S23 apporte ainsi, au lieu de la masse, la tension obtenue aux bornes de la résistance RC. Cette tension, au cours de la phase d'auto-zéro, charge le condensateur de compensation CC et viendra, lors de la mesure se soustraire à la tension d'entrée.

Le générateur de courant sera de préférence incorporé dans le circuit intégré (cadre en traits mixtes), tandis que la résistance, à l'extérieur du circuit, peut être variable ou remplaçable, afin que soit obtenue une tension de compensation appropriée à l'erreur de mesure précédemment déterminée.

De plus, le générateur de courant peut encore être réalisé sous la forme d'une structure intégrée équivalant à une fraction déterminée de l'ensemble des commutateurs et plates-formes dont il s'agit de compenser l'effet. L'avantage est alors que, sans connaître l'erreur due aux courants de fuite dans un circuit intégré particulier, on peut être assuré que le générateur produira un courant de sens et d'amplitude en rapport avec ceux-ci. Il est alors possible d'utiliser une résistance de valeur fixée, laquelle pourrait d'ailleurs, finalement, être aussi intégrée.

Par ailleurs, il est des cas où l'erreur de mesure considérée n'existe pas. Ainsi, dans les mesures de courants et tensions alternatives, du fait que le convertisseur AC/DC ne transmet pas le courant continu et aussi du fait de son impédance de sortie relativement réduite, les courants de fuite n'ont pas d'effet gênant.

On a donc prévu des moyens pour éliminer sur commande, dans des cas tels que celui-ci, la compensation de l'erreur systématique. Ces moyens prennent, dans l'exemple de la figure 1, la forme d'un commutateur S24 mettant à la masse la source de tension.

On mentionnera enfin que, par exemple dans le cas de la mesure de valeur crête, la présence du circuit MC peut modifier l'effet des courants de fuite et, par conséquent, la valeur de l'erreur de mesure. Dans un tel cas, il pourrait être approprié de procéder à une compensation spécifique, et, selon l'invention, il suffirait de prévoir une source de tension de compensation additionnelle, appropriée à cet usage particulier.

Il est bien évident que les descriptions qui précèdent n'ont été fournies qu'à titre d'exemple non limitatif et que de nombreuses variantes peuvent être envisagées sans sortir pour autant du cadre de l'invention.

REVENDICATIONS

1. Multimètre numérique à convertisseur à double-rampe comprenant des calibres d'entrée, des commutateurs d'entrée, un convertisseur analogique-numérique et un afficheur, le convertisseur analogique-numérique comprenant un étage d'entrée, un étage intégrateur et un comparateur, ainsi que des commutateurs permettant de connecter à l'entrée du convertisseur soit une masse pour la phase d'auto-zéro, soit la tension d'entrée à convertir, soit une tension de référence, la phase d'auto-zéro consistant à établir une boucle maintenant la sortie du comparateur à un niveau quasi-nul et à mémoriser dans un condensateur de compensation le niveau de tension alors présent à l'entrée de l'intégrateur, caractérisé en ce que ce multimètre comprend encore une source de tension de compensation ajustable (GC-RC) arrangée de manière à être connectée à l'entrée du convertisseur analogique-numérique, à la place de la masse, pendant la phase d'auto-zéro, afin que la tension de compensation ainsi apportée soit mémorisée dans le condensateur de compensation (CC), le signe et l'amplitude de cette tension de compensation étant tels que sa présence ultérieure dans le cycle de fonctionnement du convertisseur se traduise par une réduction d'erreurs systématiques affectant la mesure.

2. Multimètre numérique tel que défini en 1, caractérisé en ce que ladite source de tension de compensation prend la forme d'un générateur de courant de compensation (GC) inclus dans le même circuit intégré que la plupart des autres circuits actifs de l'appareil, associé à une résistance (RC) disposée à l'extérieur ou à l'intérieur de ce circuit intégré, dont la valeur peut être choisie en fonction des besoins de la compensation.

3. Multimètre numérique tel que défini en 2, caractérisé en ce que ledit générateur de courant (GC) prend la forme d'un circuit analogue dans son principe et sa constitution physique à l'ensemble des circuits qui sont cause de l'erreur à compenser.

4. Multimètre numérique tel que défini en 1, 2 ou 3, caractérisé en ce que ladite source de tension de compensation peut être éliminée et remplacée par la masse.

5. Multimètre numérique tel que défini en 4, caractérisé en ce que, pour éliminer ladite source de tension de compensation, il est prévu un commutateur additionnel (S24) la court-circuitant à la masse.

Fig.1

Fig.2

0192500

**0192500**
Numero de la demande

**RAPPORT DE RECHERCHE EUROPEENNE**

Office européen
des brevets

EP 86 40 0058

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| Y | GB-A-1 394 809 (INTEGRATED PHOTOMATRIX LTD.) * Page 3, lignes 14-82; figures 2,4 * | 1 | G 01 R 19/25 |
| | --- | | |
| Y | ELECTRONIC ENGINEERING, vol. 55, no. 683, novembre 1983, pages 153-160, London, GB; M. HICKMAN: "Hand-held DMM using multiple slope techniques * Page 153, colonne de droite; page 154, colonne de gauche; figures 2,3 * | 1,2 | |
| | --- | | |
| Y | RADIO FERNSEHEN ELEKTRONIK, vol. 32, no. 8, août 1983, pages 513-515, Berlin, DD; S. NEJCEV et al.: "MOS-Schaltkreis CM 751 für Digitalmultimeter" * Page 514, colonne de droite; page 515, colonne de gauche; figures 2-3 * | 1 | |
| | ----- | | |

| DOMAINES TECHNIQUES RECHERCHES (Int Cl 4) |
|---|
| G 01 R |

Le present rapport de recherche a ete etabli pour toutes les revendications

| Lieu de la recherche | Date d achevement de la recherche | Examinateur |
|---|---|---|
| LA HAYE | 15-04-1986 | KUSCHBERT D.E. |